# EUROPEAN PATENT APPLICATION

(11) **EP 3 564 570 A1**
(43) Date of publication of application: **06.11.2019**
(21) Application number: 16925384.6
(22) Date of filing: 30.12.2016
(51) Int. Cl.: F16M 11/00

(54) **DISPLAY DEVICE AND MOBILE TERMINAL**

(71) Applicant: SHENZHEN ROYOLE TECHNOLOGIES CO., LTD., Shenzhen Guangdong (CN)
(72) Inventor: LIAO, Le, Shenzhen Guangdong 518052 (CN)
(74) Representative: Hamer, Christopher K.
(86) International application number: PCT/CN2016/113616
(87) International publication number: WO 2018/120066

(57) **Abstract**

The present disclosure provides a display device comprising a housing having electronic components and a supporting assembly for supporting a display screen. The supporting assembly comprises a foundation support and a connecting piece. A circuit board electrically coupled to the display screen is disposed inside of the foundation support. One side of the foundation support is provided with a conductive sheet electrically coupled to the circuit board. The connecting piece comprises an abutting piece electrically coupled to the electronic components and a supporting piece extending from the abutting piece. The connecting piece is fixed to the housing. The supporting piece is electrically coupled to the conductive sheet through thimbles. The present disclosure also provides a mobile terminal. The installation of the electronic components and the circuit board in the display device of the present disclosure has advantages of being quick and convenient.

## Description

### TECHNICAL FIELD

The present disclosure relates to a display device of a mobile terminal, and in particular, to a supporting assembly for supporting a display screen of the display device.

### BACKGROUND

Existing mobile terminals support a display screen through a supporting assembly to protect the supporting assembly through housing. A circuit board is mounted in the supporting assembly. A circuit module such as a control chip is disposed on the circuit board. The surface of the housing is provided with electronic components such as a switch or a charging interface. The electronic components are typically mounted to the housing and the circuit board is mounted into the supporting assembly. The electrical connection between the electronic component and the circuit board is made by wires. When the housing is assembled with the supporting assembly, the installation process requires distraction of the operator due to the involvement of the wires. In order to avoid the disconnection of the wires, the installation process is troublesome and time consuming.

How to make the installation of electronic components and circuit boards fast and convenient, and is a continuous research of the industry.

### SUMMARY

The technical problem to be solved by the embodiments of the present disclosure is to provide a supporting assembly, which is applied to a display device. The installation of electronic components and circuit boards in the supporting assembly has advantages of being quick and convenient.

In one aspect, the present disclosure provides a display device including a housing which includes electronic components and a supporting assembly for supporting a display screen. Wherein the supporting assembly include a foundation support and a connecting piece. Inside of the foundation support is provided with a circuit board electrically coupled to the display screen. One side of the foundation support is provided with a conductive sheet electrically coupled to the circuit board; the connecting piece includes an abutting piece electrically coupled to the electronic components and a supporting piece extending from the abutting piece; the connecting piece is fixed to the housing; the supporting piece abuts against the conductive sheet through thimbles to realize electrical connections.

In another aspect, the present disclosure further provides a mobile terminal including the above display device.

The display device of the present disclosure forms an assembly by mounting the electronic components and the connecting piece on the bracket, and then mounting the bracket to the foundation support, and the connecting piece and the conductive sheet on the foundation support are electrically connected by thimbles, and the conductive sheet is fixed on the foundation support and further electrically connected to the circuit board in the foundation support. In the present disclosure, the electronic components and the connecting piece are integrated with the bracket, and the electrical connection between the connecting piece and the conductive sheet is realized by the thimbles, no wire is needed in the process of mounting the electronic components, and there is no problem that the wire is disconnected and installed, and the installation is troublesome. The process is quick and easy.

### BRIEF DESCRIPTION OF THE ACCOMPANYING DRAWINGS

In order to illustrate the embodiments of the present disclosure or the technical solutions in the prior art more clearly, the drawings to be used in the embodiments will be briefly described below. Obviously, the drawings in the following description are only some embodiments of the present disclosure, for those skill in the art, other drawings can be obtained according to the drawings without any creative work.
FIG. 1 is a schematic diagram of a display device in a contracted state according to one embodiment of the present disclosure.
FIG. 2 is a schematic diagram of the display device shown in FIG. 1 from another direction.
FIG. 3 is a schematic diagram of the display device in an expanded state according to one embodiment of the present disclosure.
FIG. 4 is a schematic diagram of the display device shown in FIG. 3 from another direction.
FIG. 5 is an exploded view of the display device according to one embodiment of the present disclosure, in which a flexible screen is not included.
FIG. 6 is an exploded view of a part of a first main body of FIG. 5.
FIG. 7 is a schematic diagram of a first housing of the first main body of FIG. 5.
FIG. 8 is a schematic diagram of a foundation support of the first main body of the supporting assembly according to one embodiment of the present disclosure, in which a first guiding rod is exploded outside of the foundation support.
FIG. 9 is an exploded view of a base plate and a rod assembly of the first main body of the supporting assembly according to one embodiment of the present disclosure.
FIG. 10 is a schematic diagram of a mounting of the base plate, the foundation support, and a first pressing plate of the first main body of the supporting assembly according to one embodiment of the present disclosure.
FIG. 11 is a schematic diagram of a second main body of the supporting assembly according to one embodiment of the present disclosure, in which a reel assembly is mounted to the second main body.
FIG. 12 is a schematic diagram of a base body of the second main body shown in FIG. 11.
FIG. 13 is a schematic diagram of a base body shown in FIG. 12 from another direction, in which the second guiding rod is exploded outside of the base body.
FIG. 14 is a schematic diagram of the second main body shown in FIG. 11 from another direction.
FIG. 15 is a schematic diagram of the rod assembly mating with the first guiding rod and the second guiding rod of the supporting assembly in an expanded state according to one embodiment of the present disclosure.
FIG. 16 is a schematic diagram of FIG. 15 from another direction.
FIG. 17 is a schematic diagram of the rod assembly mating with the first main body of the supporting assembly according to one embodiment of the present disclosure.
FIG. 18 is a schematic diagram of a first connecting rod, mating with the first main body and the second main body of the supporting assembly according to one embodiment of the present disclosure.
FIG. 19 is a schematic diagram of FIG. 18 from another direction.
FIG. 20 is a schematic diagram of a second connecting rod mating with the first main body and the second main body of a supporting assembly according to one embodiment of the present disclosure.
FIG. 21 is a schematic diagram of the rod assembly mating with the first main body of the supporting assembly according to one embodiment of the present disclosure.
FIG. 22 is a schematic diagram of FIG. 21 from another direction.
FIG. 23 is a schematic diagram of the rod assembly mating with the first guiding rod and the second guiding rod of the supporting assembly according to one embodiment of the present disclosure in the contracted state.
FIG. 24 is a schematic diagram of a rotation limiting structure of the supporting assembly according to one embodiment of the present disclosure.
FIG. 25 is an assembled cross-sectional view of the rotation limiting structure shown in FIG. 24.
FIG. 26 is a schematic diagram of a rotation limiting structure of a supporting assembly mounting on a base plate of the first main body according to one embodiment of the present disclosure.
FIG. 27 is a cross-sectional view of a display device of the present disclosure.
FIG. 28 is an exploded view of a reel assembly in the display device according to one embodiment of the present disclosure.
FIG. 29 is a partial schematic diagram of a shaft of the reel assembly according to one embodiment of the present disclosure.
FIG. 30 is a partial schematic diagram of a shaft of the reel assembly according to one embodiment of the present disclosure.
FIG. 31 is a partial schematic diagram of a shaft of the reel assembly according to one embodiment of the present disclosure.
FIG. 32 is a schematic diagram of a first end cover of the reel assembly according to one embodiment of the present disclosure.
FIG. 33 is a schematic diagram of a second end cover of the reel assembly according to one embodiment of the present disclosure.
FIG. 34 is a partial schematic diagram of a reel of the reel assembly according to one embodiment of the present disclosure.
FIG. 35 is a partial schematic diagram showing a mounting of the reel assembly to a second main body according to one embodiment of the present disclosure.
FIG. 36 is a partial schematic diagram showing a mounting of the reel assembly to the second main body according to one embodiment of the present disclosure.
FIG. 37 is a partial schematic diagram showing a mounting of the reel assembly to the second main body according to one embodiment of the present disclosure.
FIG. 38 is a partial schematic diagram showing a mounting of the reel assembly to the second main body of the supporting assembly according to one embodiment of the present disclosure.
FIG. 39 is an exploded view of an electronic component, a bracket, a connecting piece, and a button in the supporting assembly according to one embodiment of the present disclosure.
FIG. 40 is a schematic diagram of electronic component mounted to the foundation support in the supporting assembly according to one embodiment of the present disclosure.
FIG. 41 is a schematic diagram of a structural member shown in FIG. 39 from another direction.
FIG. 42 is a schematic diagram of a mounting of the electronic component, bracket and button to the foundation support shown in FIG. 39.
FIG. 43 is a schematic diagram of a mounting of the electronic component, the bracket, the connecting piece and the button to the foundation support and the first housing shown in FIG. 39.
FIG. 44 is a schematic diagram of a mounting of the electronic component, the bracket, the connecting piece and the button to the first housing without being mounted to the base shown in FIG. 39.
FIG. 45 is a partially exploded view of a display device according to one embodiment of the present disclosure.
FIG. 46 is a partial cross-sectional view of the display device shown in FIG. 45.

### DETAILED DESCRIPTION OF ILLUSTRATED EMBODIMENTS

The technical solutions in the embodiments of the present disclosure are clearly and completely described in the following with reference to the drawings in the embodiments of the present disclosure. It is obvious that the described embodiments are only a part of the embodiments of the present disclosure, and not all of the embodiments. All other embodiments obtained by a person of ordinary skill in the art based on the embodiments of the present disclosure without departing from the inventive scope are the scope of the present disclosure.

The terms "first", "second", "third", "fourth", etc. (if present) in the specification and claims of the present disclosure and the above figures are used to distinguish similar objects, without being used to describe a specific order or a precedence order.

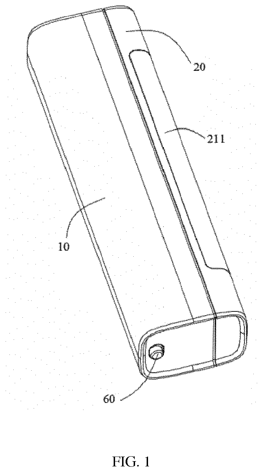

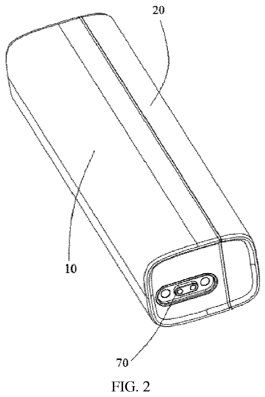

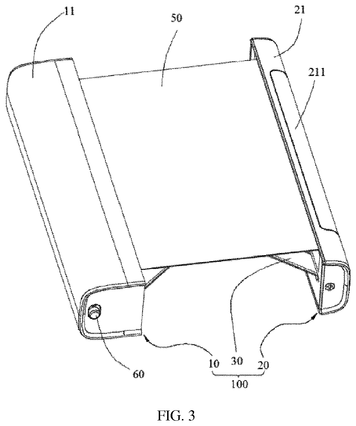

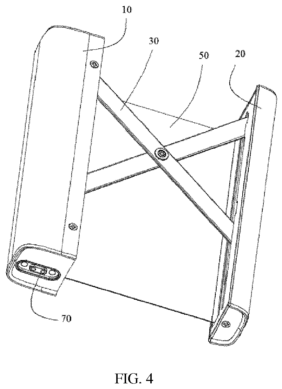

The present disclosure relates to a display device of a mobile terminal. The display device has a function of expanding and contracting. FIGS. 1 and 2 show the display device in a contracted state. FIGS. 3 and 4 show the display device in an expanded state. The display device includes a supporting assembly 100 and a reel assembly. The supporting assembly 100 is used for supporting a flexible screen 50. The reel assembly is used for winding the flexible screen 50. In the display device shown in FIGS. 1 to 4, the reel assembly is hidden inside of the supporting assembly 100.

The supporting assembly 100 includes a first main body 10 and a second main body 20 opposite to the first main body 10, and a rod assembly 30 coupling the first main body 10 to the second main body 20. The rod assembly 30 includes at least two connecting rods hinged to each other to form a telescopic structure, such that the first main body 10 and the second main body 20 can relatively contract or expand. The first main body 10 is used for fixing one end of the flexible screen 50. A reel assembly is installed in the second main body 20. The flexible screen 50 is wound on the reel assembly. During a process from the contracted state to the expanded state, the flexible screen 50 is pulled out and released from the reel assembly.

The supporting assembly 100 includes a housing. The housing houses inner structure. Specifically, the housing includes a first housing 11 located on the first main body 10 and a second housing 21 located on the second main body 20. The second housing 21 includes a window portion 211. When the display device is in the contracted state, a display interface of the flexible screen 50 can be seen through the window portion 211 of the second housing 21. A switch module button 60 is mounted on one end of the first housing 11 and a charging interface 70 is mounted at the other end of the first housing 11.

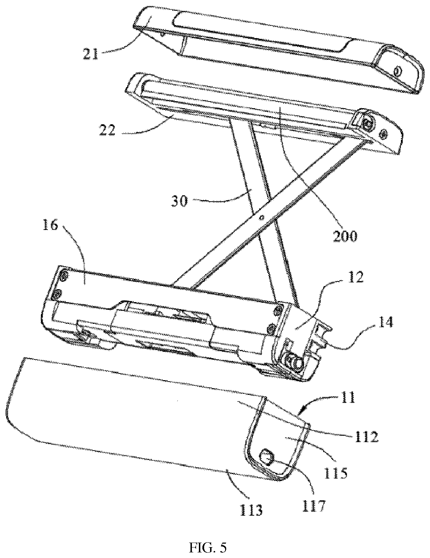

Referring to FIGS. 5, 6, and 7, the first main body 10 includes a foundation support 12, a base plate 14, and a first pressing plate 16. The foundation support 12, the base plate 14, and the first pressing plate 16 are stacked in sequence. The base plate 14 and the first pressing plate 16 are respectively located at two sides of the foundation support 12. The second main body 20 includes a base body 22. The reel assembly 200 is mounted to the base body 22.

The first housing 11 includes a top surface 112, a bottom surface 114 opposite to the top surface 112, a side surface 113 coupled to one side of the top surface 112 and the bottom surface 114, and a front end surface 115 and a rear end surface 116 each coupled the top surface 112, the bottom surface 114, and the side surface 113. The top surface 112, the bottom surface 114, the front end surface 115 and the rear end surface 116 cooperatively form a first opening. The foundation support 12, the base plate 14, and the first pressing plate 16 are assembled and then placed into the first housing 11 through the first opening. The front end surface 115 of the first housing 11 defines a through hole 117 for receiving the switch module button 60. The rear end surface 116 of the first housing 11 defines a through hole 118 for receiving the charging interface 70. Specifically, the top surface 112 and the side surface 113 of the first housing 11 have a circular arc transition. The bottom surface 114 and the side surface 113 of the first housing 11 may also have a circular arc transition. In one embodiment, the top surface 112, the side surface 113 and bottom surface 114 can also cooperatively form a U-shaped structure.

The second housing 21 is similar to the first housing 11. As shown in FIG. 5, a top surface, a side surface, and a bottom surface of the second housing 21 cooperatively form a C-shaped structure. The window portion 211 is located at a connecting portion of the top surface and the side surface of the second housing 21. The front end surface and the rear end surface of the second housing 21 may define screw holes; Screws each pass through one of the screw holes to enable the second housing 21 to be fixed to the base body 22 of the second main body 20.

The present disclosure sets a first limiting part and a first guiding rod on the first main body 10, and a second limiting part and a second guiding rod on the second main body 20. The rod assembly 30 includes a first fixed end and a second moving end respectively located at a pair of diagonal positions of the rod assembly 30, and a second fixed end and a first moving end respectively located at another pair of diagonal positions of the rod assembly 30. The first fixed end and the first limiting part are combined to form a rotating shaft structure. The second fixed end and the second limiting part are combined to form a rotating shaft structure. The first moving end is slidably coupled to the first guiding rod. The second moving end is slidably coupled to the second guiding rod. During a process of expanding and contracting of the rod assembly 30, the first moving end and the second moving end slide on the first guiding rod and the second guiding rod respectively, thereby achieving a change of a distance between the first main body 10 and the second main body 20. Moreover, the first guiding rod and the second guiding rod provide a sliding trajectory and a guidance, since the surfaces of the first guiding rod and the second guiding rod are smooth, the coordination between the first moving end and the first guiding rod, and the coordination between the second guiding rod and the second moving end are smooth, and there is no stuck phenomenon due to friction. It can also add lubricating oil at the interface between the first moving end and the first guiding rod 126, or the second guiding rod 226 and the second moving end 34 to improve the smoothness of expanding and contracting of the rod assembly 30.

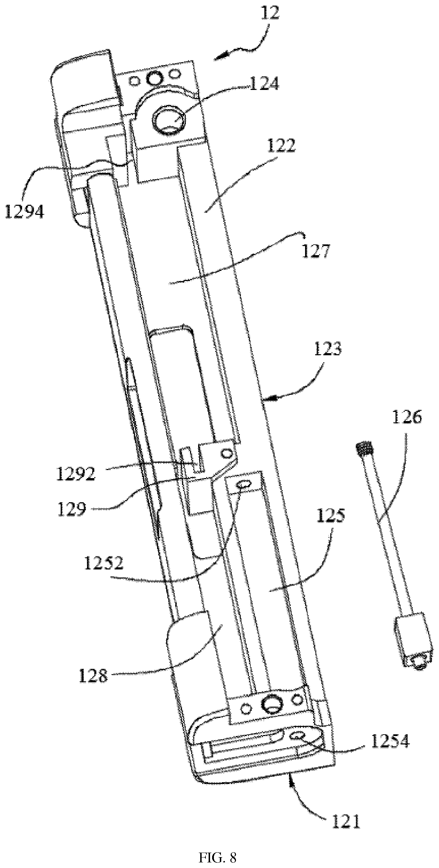

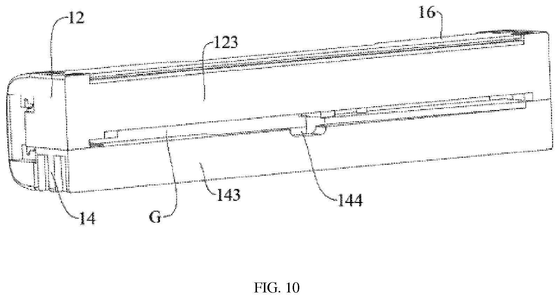

Referring to FIG. 8 and FIG. 10, the foundation support 12 includes a top surface 121 and a bottom surface 122 opposite to the top surface 121, and a first side surface 123 adjacent to the bottom surface 122. Specifically, the top surface 121 of the foundation support 12 is used for supporting the flexible screen 50. The first pressing plate 16 is fixed to the top surface 121 of the foundation support 12. The flexible screen 50 is located between the first pressing plate 16 and the foundation support 12. Setting the first pressing plate 16 causes the flexible screen 50 to be evenly attached to the top surface 121 of the foundation support 12 during a process of expanding or contracting of the display device to ensure a flatness of the flexible screen 50. Of course, the first main body 10 may not include the first pressing plate 16, and the flexible screen 50 may be directly located between the housing (ie, the first housing 11) and the top surface 121 of the foundation support 12, but this design manner should ensure a fit tolerance between the first housing 11 and the foundation support 12 to be suitable.

The bottom surface 122 of the foundation support 12 includes a first limiting part 124 and a limiting slot 125. The first limiting part 124 has a shape of axial hole. The first guiding rod 126 is installed into the limiting slot 125. Specifically, the limiting slot 125 has a stripe shape. Two end surfaces of the limiting slot 125 respectively define receiving holes 1252 and 1254. The receiving hole 1254 cuts through one end of the foundation support 12 and interconnects with the outside of the foundation support 12. The first guiding rod 126 passes through the receiving hole 1254 from the outside of the foundation support 12 and reaches into the limiting slot 125 and one end of the first guiding rod 126 is further inserted into the receiving hole 1252 to install the first guiding rod 126 in the limiting slot 125. The receiving hole 1252 is a threaded hole. The one end of the first guiding rod 126 includes threads. The bottom surface 122 of the foundation support 12 defines a circuit cavity 127 and a battery cavity 128. The circuit cavity 127 is used for housing the circuit board. The battery cavity 128 is used for housing the battery. The battery cavity 128 is located on one side of the limiting slot 125 away from the first side surface 123. The circuit cavity 127 is located between the battery cavity 128 and the first limiting part 124. A buckle 129 is located between the battery cavity 128 and the circuit cavity 127. The buckle 129 defines a first slot 1292. One side of the first limiting part 124 away from the first side surface 123 defines a second slot 1294. The first slot 1292 and the second slot 1294 are located opposite to each other and are used for locating the circuit board cooperatively.

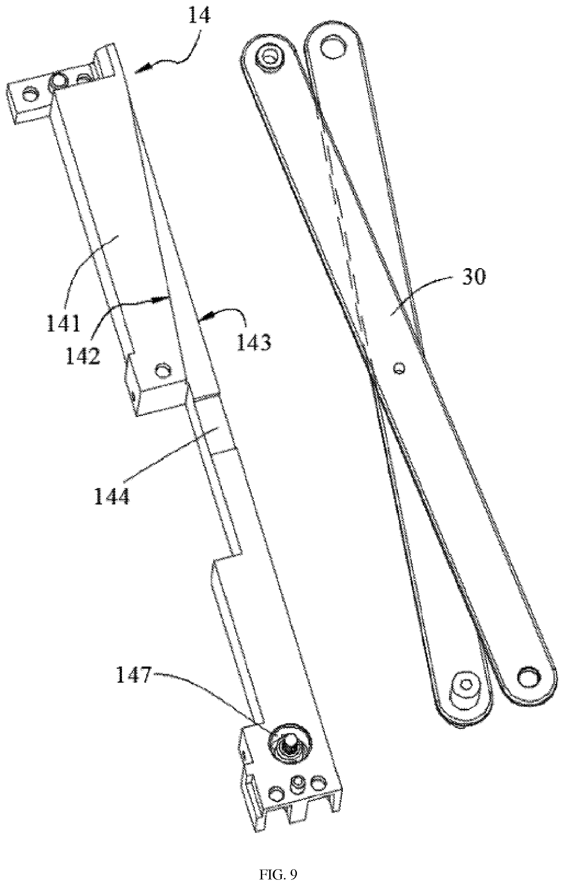

Referring to FIGS. 9 and 10, the base plate 14 is mounted to the bottom surface 122 of the foundation support 12. A gap G is defined between the base plate 14 and the foundation support 12. The gap G has an opening at the first side surface 123 for the rod assembly 30 to reach in or protrude from the gap G. A surface of the base plate 14 facing the bottom surface 122 of the foundation support 12 includes a step 142. The step 142 is used for limiting the rod assembly 30 in the contracted state.

The base plate 14 includes a top surface 141 facing the bottom surface 122 of the foundation support 12 and a second side surface 143 adjacent to the top surface 141. The top surface 141 defines a relief groove 144. The relief groove 144 forms an opening at the second side surface 142.

The second side surface 143 of the base plate 14 is coplanar with the first side surface 123 of the foundation support 12. The first side surface 123 and the second side surface 141 are both planar. The base plate 14 and the foundation support 12 are positioned by studs cooperating with positioning holes, and then fixed by screws.

The connecting rod of the rod assembly 30 includes a first connecting rod and a second connecting rod. A center position of the first connecting rod and a central position of the second connecting rod are combined to a hinged structure through a connecting member. When the rod assembly 30 is in the contracted state, the first connecting rod and the second connecting rod are contracted and received in the gap G, and the connecting member is received in the relief groove 144. In one embodiment, the connecting member is a screw.

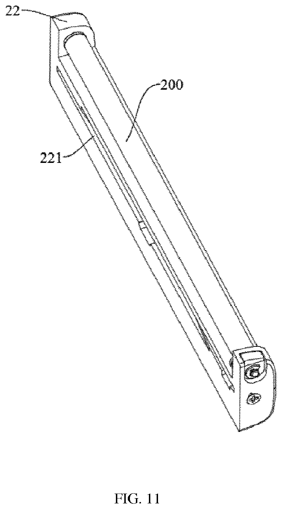

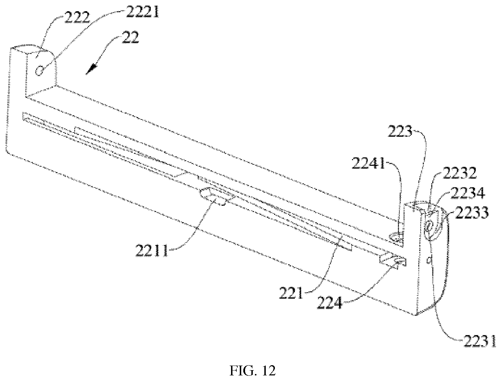

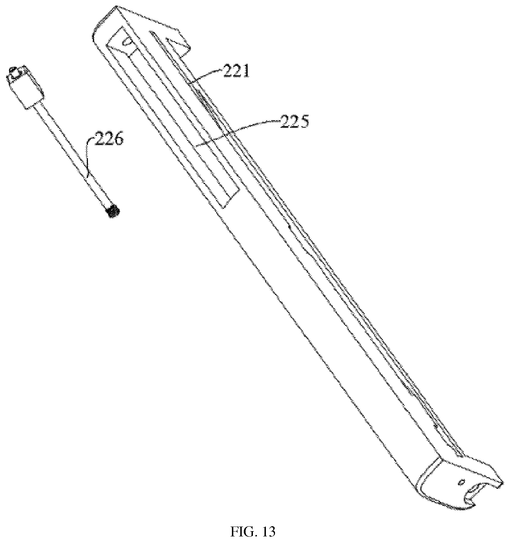

Referring to FIGS. 11, 12, 13 and 14, the second main body 20 includes a base body 22. One side surface of the base body 22 opposite to the foundation support 12 defines a slot 221 for receiving the rod assembly 30. The second limiting part 224 is located in the slot 221. The second limiting part 224 is in a shape of screw hole. The top surface of the base body 22 defines a through hole 2241 corresponding to the second limiting part 224. The bottom surface of the base body 22 defines a receiving slot 225 (see FIG. 13). The receiving slot 225 interconnects with the slot 221. The second guiding rod 226 is installed in the receiving slot 225. The specific structure in which the second guiding rod 226 is installed in the receiving groove 225 is the same as the specific structure in which the first guiding rod 126 is installed in the limiting slot 125.

A middle position of the slot 221 defines a relief groove 2211. The relief groove 2211 is located opposite to the relief groove 144 of the first main body 10. When the display device is contracted, the relief groove 2211 and the relief groove 144 together receive the connecting member hinged the first connecting rod and the second connecting rod.

The top surface of the base body 22 includes a mounting portion for mounting the reel assembly 200. The reel assembly 200 is used for winding the flexible screen 50. The mounting portion includes a first mounting portion 222 and a second mounting portion 223 opposite to the first mounting portion 222. The first mounting portion 222 and the second mounting portion 223 are respectively located at two opposite end surfaces of the base body 22. The first mounting portion 222 and the second mounting portion 223 cooperatively form a space for receiving the reel assembly 200. In one embodiment, the first mounting portion 222 and the second mounting portion 223 are integrally formed with the base body 22.

The first mounting portion 222 defines a through hole 2221. The second mounting portion 223 defines a through hole 2231. The through hole 2221 and the through hole 2231 are coaxial and used for mounting the reel assembly 200. The second mounting portion 223 defines a locking groove 2232 and an inner concave portion 2233. The inner concave portion 2233 is located at one side of the second mounting portion 223 away from the first mounting portion 222. A spacing plate 2234 is located between the inner concave portion 2233 and the locking groove 2232. The locking groove 2232 and the inner concave portion 2233 both interconnect with the through hole 2231.

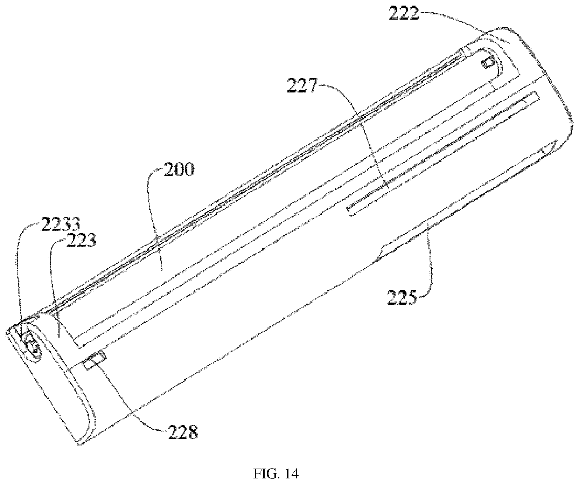

As shown in FIG. 14, a surface of the base body 22 away from the first main body 10 defines slits 227, 228. The slits 227, 228 interconnect with the slot 221 for receiving and supporting the rod assembly.

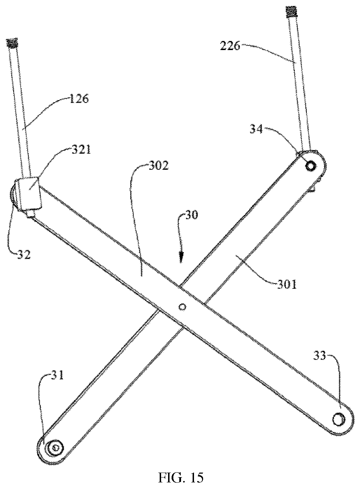

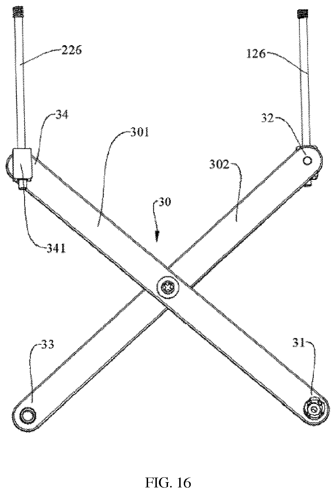

FIGS. 15 and 16 are schematic diagrams of the rod assembly 30 mating with the first guiding rod 126 and the second guiding rod 226.

The rod assembly 30 includes a first connecting rod 301 and a second connecting rod 302 hinged to the first connecting rod 301. The rod assembly 30 further includes a first fixed end 31 and a second moving end 34 respectively located at a pair of diagonal positions of the rod assembly 30, and a second fixed end 33 and a first moving end 32 respectively located at another pair of diagonal positions of the rod assembly 30. The first fixed end 31 is mating to the first limiting part 124 to form a rotating shaft structure. The second fixed end 33 is mating to the second limiting part 224 to form a rotating shaft structure. The first moving end 32 slidably couples to the first guiding rod 126. The second moving end 34 slidably couples to the second guiding rod 226. During the process of expanding and contracting of the rod assembly 30, the first moving end 32 and the second moving end 34 respectively slide on the first guiding rod 126 and the second guiding rod 226 to achieve a change of a distance between the first main body 10 and the second main body 20. The first moving end 32 includes a slider 321 fixed at one end of the second connecting rod 302. The slider 321 is sleeved on the first guiding rod 126 and is in smooth contact with the first guiding rod 126. During the process of expanding and contracting of the rod assembly 30, the slider 321 slides on the first guiding rod 126. Similarly, the second moving end 34 includes a slider 341 fixed to one end of the first connecting rod 301. The slider 341 is smoothly sleeved on the second guiding rod 226. During the process of expanding and contracting of the rod assembly 30, the slider 341 slides on the second guiding rod 226. An orientation of the slider 341 on the first connecting rod 301 is opposite to an orientation of the slider 321 on the second connecting rod 302.

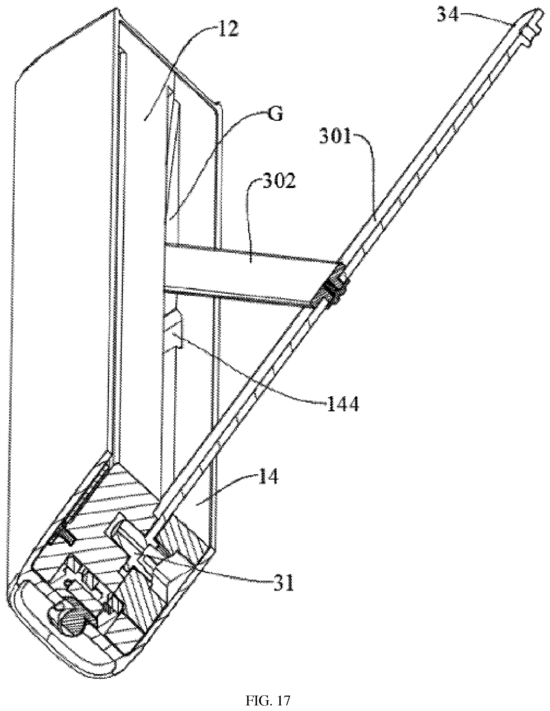

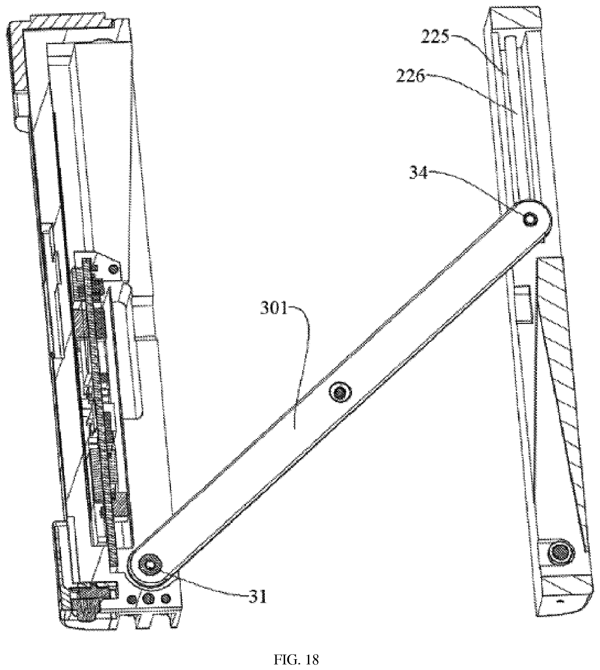

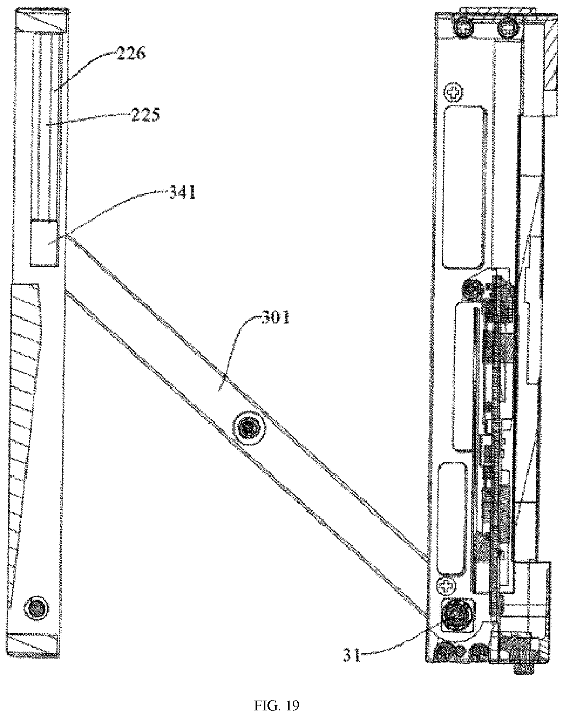

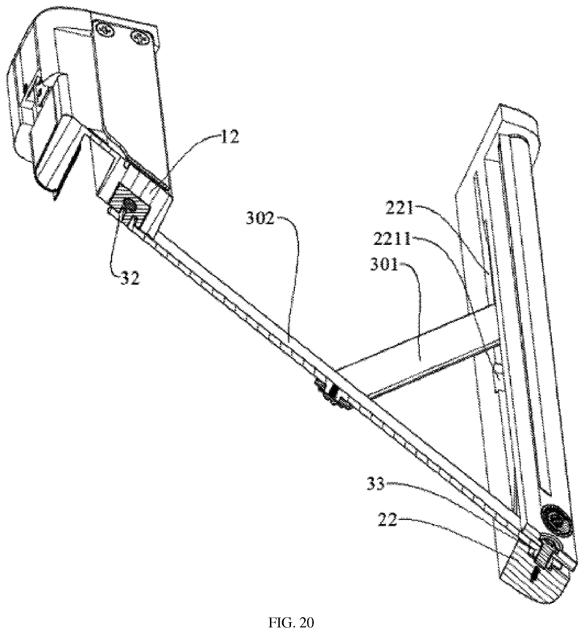

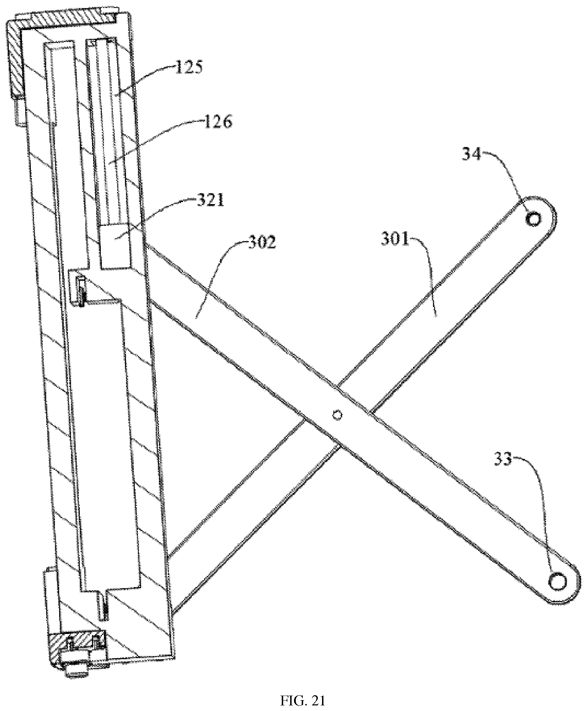

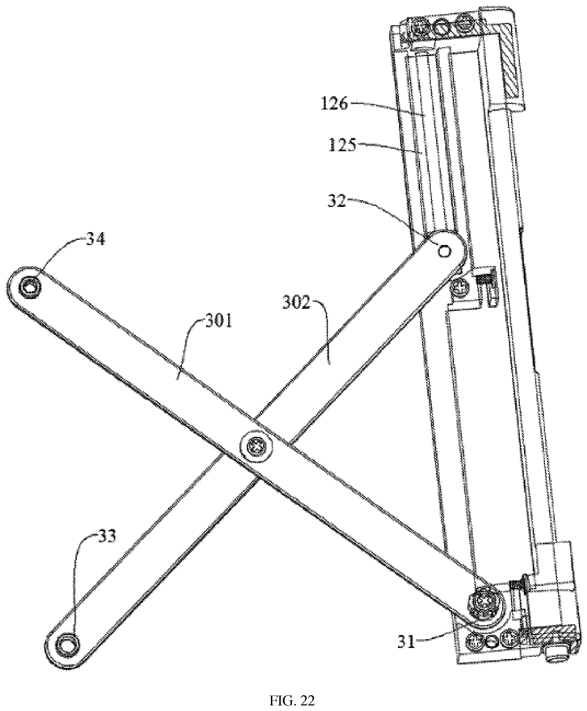

One end of the first connecting rod 301 away from the slider 341 is set to be the first fixed end 31. One end of the second connecting rod 302 away from the slider 321 is set to be the second fixed end 33. FIGS. 17, 18, and 19 are schematic diagrams of the first connecting rod 301 mating with the first main body 10 and the second main body 20. In the process of approaching or separating between the first main body 10 and the second main body 20, the first connecting rod 301 rotates around first fixed end 31 relative to the first main body 10 while the slider 341 on the second moving end 34 slides on the second guiding rod 226. An angle between the first connecting rod 301 and the first main body 10 varies with the change of the distance between the first main body 10 and the second main body 20. When the first main body 10 and the second main body 20 are close to each other, the angle between the first connecting rod 301 and the first main body 10 becomes smaller. When the first main body 10 and the second main body 20 are away from each other, and the angle between the first connecting rod 301 and the first main body 10 becomes greater. FIGS. 20, 21 and 22 are schematic diagrams of the second connecting rod 302 mating with the first main body 10 and the second main body 20, and the second fixed end 33 is screwed onto the base body 22 of the second main body 20. During the process of approaching or separating between the first main body 10 and the second main body 20, the motions of the first connecting rod 301 and the second connecting rod 302 are synchronized.

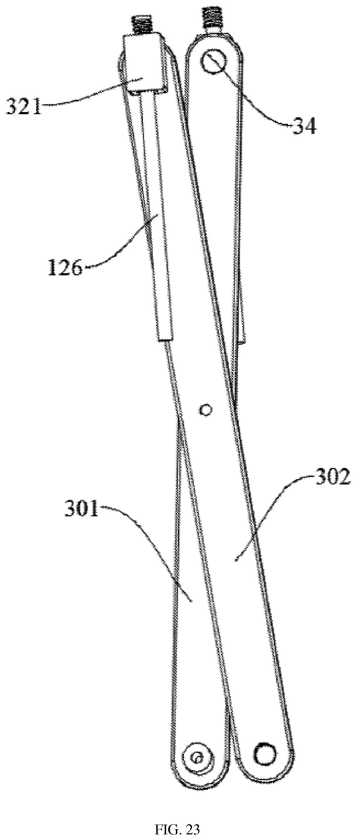

Referring to FIG. 23, when the first connecting rod 301 and the second connecting rod 302 are in the contracted state, the first guiding rod 126 overlaps the first connecting rod 301, the second guiding rod 226 overlaps the second connecting rod 302, the slider 341 on the first connecting rod 301 is located at one end of the first guiding rod 126, and the slider 321 on the second connecting rod 302 is located at one end of the second guiding rod 226. Referring to FIGS. 15 and 16, when the first connecting rod 301 and the second connecting rod 302 are in the expanded state, the first guiding rod 126 is staggered with the first connecting rod 301, and the slider 341 on the first connecting rod 301 is located at the other end of the first guiding rod 126. The second guiding rod 226 is staggered with the second connecting rod 302, and the slider 321 on the second connecting rod 302 is located at the other end of the second guiding rod 226.

The supporting assembly of the present disclosure includes a rotation limiting structure. The first main body 10 is positioned at different positions relative to the second main body 20 through the rotation limiting structure during the expanding or contracting process.

In this embodiment, the rotation limiting structure is located at the position of the first fixed end 31. In other embodiments, the rotation limiting structure may also be located at the position of the second fixed end 33, or may be located at a position where the first connecting rod and the second connecting rod are hinged to each other, as long as the first connecting rod and the second connecting rod can be ensured to be limited at any positions in a rotating process, or can be limited to specified positions, thereby realizing positioning of the display device during the contracting or expanding process.

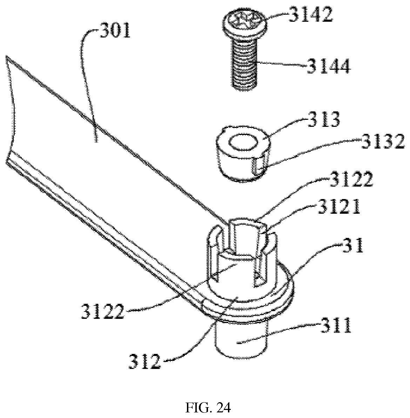

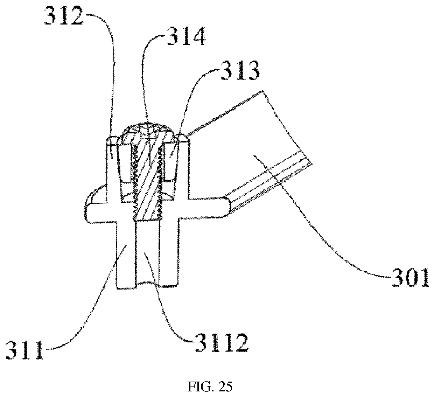

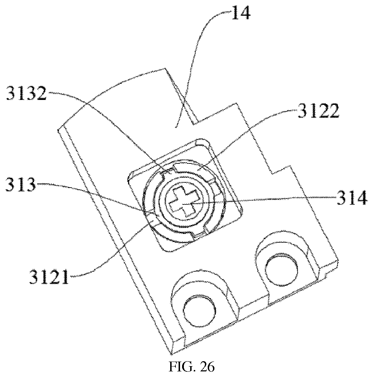

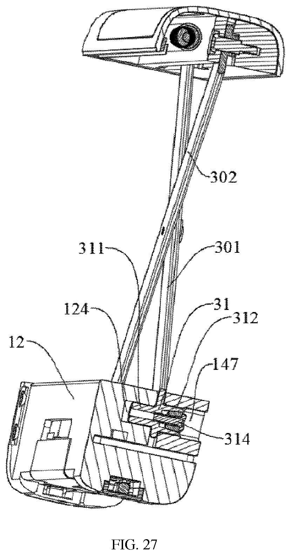

Referring to FIGS. 24, 25, 26 and 27, the rotation limiting structure is located at a rotational connecting position of the first fixed end 31 and the first main body 10. Specifically, the base plate 14 defines an opening 147 (referring to FIGS. 9 and 27). The opening 147 faces the first limiting part 124. The first limiting part 124 has a shape of axial hole. The opening 147 of the base plate 14 is coaxial with first limiting part 124. The first fixed end 31 includes a convex shaft 311 and a convex ring 312 respectively located on two sides of the first connecting rod 301. The convex shaft 311 is coaxial with the convex ring 312. The convex shaft 311 is engaged with the first limiting part 124. The convex ring 312 is received in the opening 147. The friction between the convex ring 312 and an inner wall of the opening 147 performs as a limit effect in the process of expanding and contracting of the rod assembly 30. That is, in the process of expanding and contracting of the rod assembly 30, the first connecting rod 301 rotates around the first fixed end 31, the first fixed end 31 rotates in situ relative to the first main body 10, the convex ring 312 rotates in the opening 147, the convex ring 312 and the inner wall of the opening 147 forms damping in the rotating process, and the damping force is a friction between the convex ring 312 and the inner wall of the opening 147. The friction can offset a resilience of spring of the reel assembly 200, so that the expanded flexible screen 50 can be positioned at any positions.

The rotation limiting structure further includes a sleeve 313 and a fastener 314. The convex ring 312 defines a plurality of slots 3121. Each of the plurality of slots 3121 extends along a direction from one end of the convex ring 312 away from the first connecting rod 301 to the first connecting rod 301. Each two adjacent slots 3121 cooperatively form a bulge 3122. Setting the plurality of slots 3121 enables the bulges 3122 to have an ability of elastically deformable in a radial direction. The sleeve 313 has a tapered outer surface, and is received in the convex ring 312 and is attached to the inner surfaces of all the bulges 3122. The fastener 314 passes through the sleeve 313 and is fixed to the first connecting rod 301, such that, the sleeve 313 can be fixed in the convex ring 312, which causes the bulges 3122 to expand outwardly. That is, by the fastener 314 mating with and the sleeve 313, the sleeve 313 is moved into the convex ring 312 (ie, moved toward the first connecting rod 301). Due to the tapered outer surface of the sleeve 313, during a moving process of the sleeve 313, the bulges 3122 are pushed to expand outwardly, thereby increasing the friction between the convex ring 312 and the inner wall of the opening 147.

The outer surface of the sleeve 313 includes at least one rib 3132. Each rib 3132 mates with one slot 3121 to prevent the sleeve 313 from rotating relative to the convex ring 312, thereby securing a moving direction of the sleeve 313. The depth of the slot 3121 (i.e., the dimension of the slot 3121 extending in the axial direction of the convex ring 312) is larger than the length of the rib 3132 (i.e., the dimension of the rib 3132 extending in the axial direction of the convex ring 313), so that a space that ensures the sleeve 313 to be able to move relative to the convex ring 312 is reserved.

The fastener 314 is a screw. The fastener 314 includes a head portion 3142 and a screw 3144. The first connecting rod 301 defines a screw hole. The screw hole cuts through the first connecting rod 301. The head portion 3142 of the fastener 314 abuts against one end surface of the sleeve 313 away from the first connecting rod 301. The screw 3144 of the fastener 314 engages with the screw hole. In this embodiment, the convex shaft 311 has a hollow structure, that is, the convex shaft 311 defines a central hole 3112. The central hole 3112 of the convex shaft 311 interconnects with the screw hole of the first connecting rod 301, and the apertures of the central hole 3112 and the screw hole of the first connecting rod 301 can be the same. Thus, the fastener 314 can be locked in the central hole 3112 of the convex shaft 311.

In one embodiment, the convex ring 312 and the inner wall of the opening 147 of the base plate 14 may be disposed as a part of a ground path. Specifically, the first connecting rod 301 and the convex ring 312 are both made of conductive materials, and may be made of metal materials. The convex ring 312 and the first connecting rod 301 may be fixed by welding or bonding, or may be integrally formed. The base plate 14 is also made of conductive materials. The base plate 14 electrically couples to a ground of the circuit board in the first main body 10, and can electrically couples through a grounding shrapnel or electrically coupled through a wire. Thus, the grounding of the rod assembly 30 can be achieved by the convex ring 312 being in contact with the inner wall of the opening 147. The grounding of the rod assembly 30 and the base body 22 can reduce the electromagnetic interference of the metal parts with the circuit in the display device. For example, if the antenna module is arranged on the circuit board in the display device, the metal parts may cause interference with the signal transmission and reception of the antenna module; if the above grounding settings are included, the interference will be reduced and the quality of signal transmission and reception will be improved.

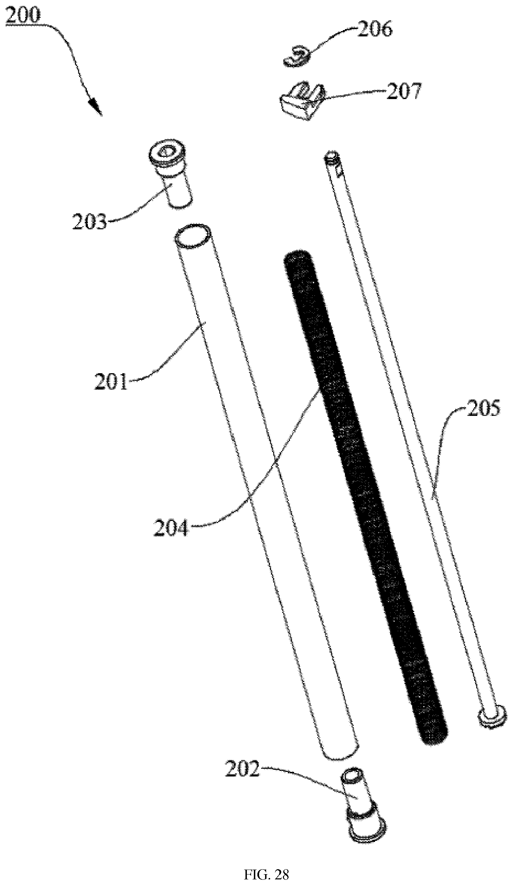

Referring to FIG. 28, the reel assembly 200 provided by the present disclosure is disposed in the supporting assembly 100 which is capable of expanding and contracting, and further supporting the flexible screen 50. The reel assembly 200 includes a reel 201, a first end cover 202, a second end cover 203, a spring 204 and a shaft 205. The shaft 205 is fixed to the supporting assembly 100. The spring 204 is sleeved on the shaft 205. The reel 201 is sleeved on an outer periphery of the spring 204. The first end cover 202 is sleeved at one end of the shaft 205 and fixedly coupled to one end of the reel 201. The second end cover 203 is sleeved to the other end of the shaft 205 and further fixed to the shaft 205. The second end cover 203 is rotatably coupled to the other end of the reel 201. Two ends of the spring 204 are respectively fixed to the first end cover 202 and the second end cover 203. The reel 201 is used for winding the flexible screen 50. The expanding of the flexible screen 50 drives the reel 201 to rotate.

When the reel 201 rotates, the first end cover 202 rotates with the reel 201, and the second end cover 203 does not rotate with the reel 201. When the reel 201 rotates, one end of the spring 204 rotates with the first end cover 202, and the other end of the spring 204 remains stationary relative to the second end cover 203, thereby generating a resilience. The spring 204 is received in the reel 201. When the reel 201 rotates, the spring 204 is twisted to generate the resilience.

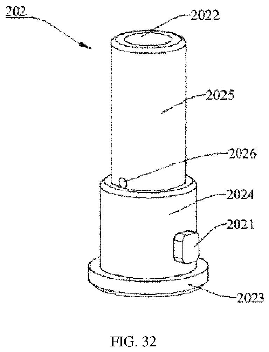

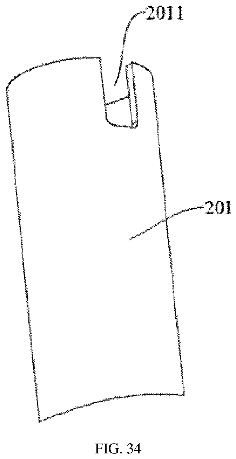

Referring to FIGS. 32, 34 and 35, the first end cover 202 and the reel 201 are limited circumferentially through a bump engaging with a slot. In one embodiment, the reel 201 has a hollow tubular structure with opening at two ends thereof. One end of the reel 201 engaged with the first end cover 202 defines a slot 2011. The outer surface of the first end cover 202 has a bump 2021. When the first end cover 202 is inserted into the reel 201 from the opening of one end of the reel 201, the bump 2021 is inserted into the slot 2011, which causes the first end cover 202 and the reel 201 to be fixedly coupled in a circumferential direction, to prevent the first end cover 202 from rotating relative to the reel 201. In other embodiments, the bump may be located on the inner surface of the reel 201, and the slot may be defined on the first end cover 202 in the same manner as described above.

The first end cover 202 defines a through hole 2022 extending axially. The through hole 2022 enables the shaft 205 to pass through. The through hole 2022 is a central through hole of the first end cover 202, that is, the center of the first end cover 202 is the axis of the through hole.

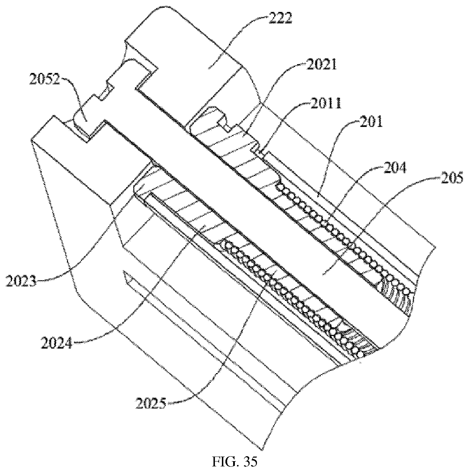

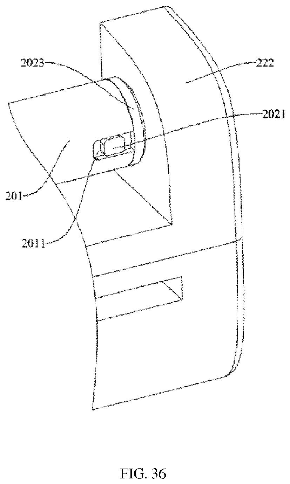

The first end cover 202 includes a base 2023, a collar 2024 and a sleeve 2025. Outer diameter of the base 2023, the collar 2024 and the sleeve 2025 are decreased sequentially. The first end cover 202 has a stepped cylindrical structure. The base 2023 has a smallest dimension in the axial direction. The base 2023 covers one end of the reel 201. A stepped surface of the base 2023 facing the collar 2024 is opposite to an end surface of the reel 201. The outer surface of the base 2023 is coplanar with an outer surface of the reel 201. The collar 2024 is in contact with the inner surface of the reel 201. As shown in FIG. 36, the bump 2021 is located at a periphery of the collar 2024. The reel 201 defines the slot 2011. The slot 2011 forms an opening at the end surface of the reel 201 for the bump 2021 inserted therein. As shown in FIG. 35, the stepped surface of the collar 2024 facing the sleeve 2025 is used for abutting one end of the spring 204 sleeved on the sleeve 2025.

A position of the sleeve 2025 adjacent to the collar 2024 defines a fixing hole 2026 for fixing the spring 204.

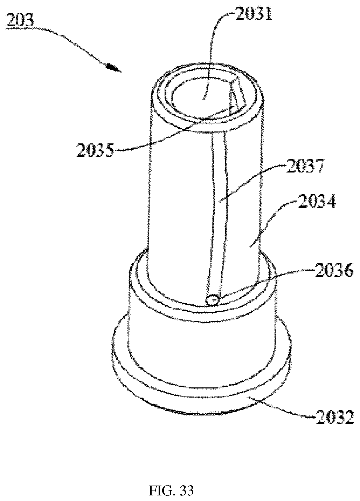

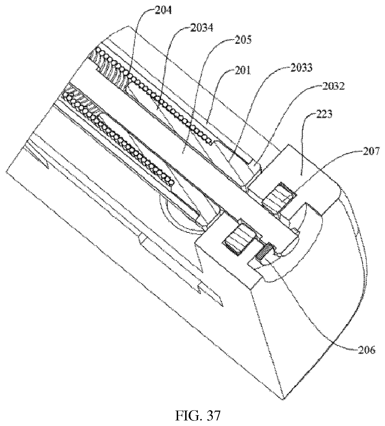

Referring to FIGS. 33 and 37, the second end cover 203 defines a through hole 2031 extending axially. The through hole 2031 enables the shaft 205 to pass through. The second end cover 203 includes a base 2032, a collar 2033 and a sleeve 2034. Outer diameter of the base 2032, the collar 2033 and the sleeve 2034 are decreased sequentially. The collar 2033 is attached to the inner surface of the reel 201 to form a rotating shaft structure. The stepped surface of the base 2032 facing the collar 2033 is opposite to another end surface of the reel 201. The outer diameter of the base 2032 is the same as the outer diameter of the reel 201, i.e., the outer surface of the base 2032 is coplanar with the outer surface of the reel 201. After the first end cover 202 and the second end cover 203 are mounted on two ends of the reel 201, the outer surfaces of the first end cover 201 and the second end cover 203 cooperatively form a unitary cylindrical structure. A stepped surface of the collar 2033 facing the sleeve 2034 is used for abutting one end of the spring 204 sleeved on the sleeve 2034. The inner side surface of the through hole 2031 includes a limiting surface 2035. The limiting surface 2035 engages with the shaft 205 to fix the second end cover 203 to the shaft 205 in the circumferential direction.

The sleeve 2034 includes a sleeve end surface located at one end of the sleeve 2034 away from the collar 2033 and a sleeve side surface coupled between the sleeve end surface and the collar 2033. The sleeve side surface defines a fixing hole 2036 and a guiding groove 2037. The fixing hole 2036 is used for fixing the spring 204. The guiding groove 2037 extends from the fixing hole 2036 to an intersection between the sleeve side surface and the sleeve end surface.

During assembly, firstly, the shaft 205 passes through the first end cover 202; the spring 204 is sleeved on the shaft 205; one end of the spring 204 is sleeved on the sleeve 2025 of the first end cover 202; the reel 201 is sleeved at a periphery of the spring 204, such that one end of the reel 201 is coupled to the first end cover 202; the bump 2021 of the first end cover 202 is engaged with the slot 2011 of the reel 201; the second end cover 203 is further mounted at the other end of the reel 201; during assembly of the second end cover 203, the guiding groove 2037 of the second end cover 203 is first aligned with the other end of the spring 204. During assembly, the other end of the spring 204 is moving in the guiding groove 2037; when the other end of the spring 204 moves to meet the fixing hole 2036 of the second end cover 203, the other end of the spring 204 is automatically snapped into the fixing hole 2036, thereby completing to assemble the second end cover 203.

The supporting assembly 100 includes a first mounting portion 222 and a second mounting portion 223 opposite to the first mounting portion 222. The spring 204, the first end cover 202, the reel, and the second end cover 203 are located between the first mounting portion 222 and the second mounting portion 223. The shaft 205 passes through the first mounting portion 222, the first end cover 202, the spring 204, the reel and the second end cover 203 sequentially, and are further fixed to the second mounting portion 223.

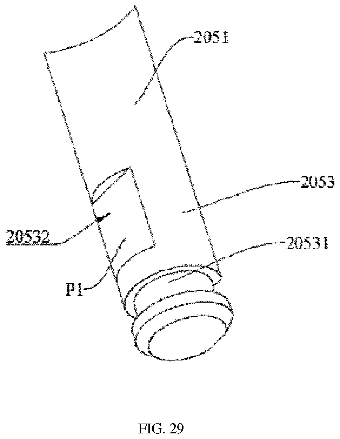

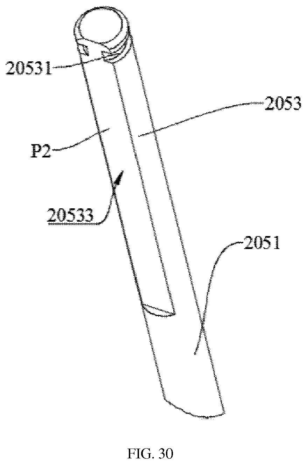

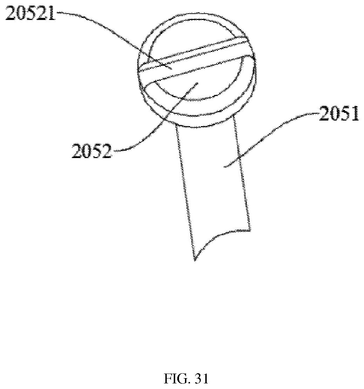

Referring to FIGS. 29, 30 and 31, the shaft 205 includes a rod member 2051 and a head end 2052 located at one end of the rod member 2051. One end of the rod member 2051 away from the head end 2052 is the fixed end 2053. The head end 2052 is limited to one side of the first mounting portion 222 away from the second mounting portion 223. The fixed end 2053 is fixedly coupled to the second mounting portion 223. The end surface of the head end 2052 away from the rod member 2051 defines a strip groove 20521 for use with a locking tool. The fixed end 2053 defines an annular groove 20531 for engaging with the clasp 206 to realize positioning of the shaft 205 in the axial direction to prevent the shaft 205 from falling off the supporting assembly 100. The fixed end 2053 defines a notch 20532 and a slot 20533. The notch 20532 and the slot 20533 are located on opposite sides of the fixed end 2053 in the radial direction. The bottom surface of the notch 20532 forms a first stopping surface P1. The bottom surface of the slot 20533 forms a second stopping surface P2. The first stopping surface P1 is parallel to the second stopping surface P2.

The limiting surface 2035 extending axially in the through hole 2031 of the second end cover 203 is used for mating with the second stopping surface P2, so as to fix the second end cover 203 to the shaft 205 in the circumferential direction.

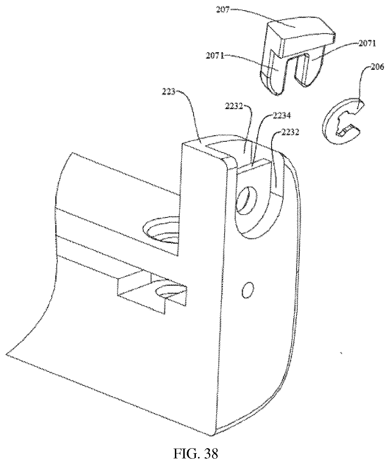

Referring to FIG. 38, the reel assembly further includes a buckle 207 and a clasp 206. The buckle 207 includes a pair of fastening pins 2071. The pair of fastening pins 2071 are respectively engaged with the notch 20532 and the slot 20533 to achieve positioning of the shaft 205 in the circumferential direction. The second mounting portion 223 defines a locking groove 2232 and an inner concave portion 2233. The inner concave portion 2233 is located at one side of the second mounting portion 223 away from the first mounting portion 222. A spacing plate 2234 is located between the inner concave portion 2233 and the locking groove 2232. The second mounting portion 223 defines a through hole 2231 extending along an axial direction of the shaft 205. The locking groove 2232 and the inner concave portion 2233 are both interconnected with the through hole 2231. The buckle 207 is received in the locking groove 2232, and the buckle 207 is engaged with the notch 20532 and the slot 20533 of the shaft 205. The clasp 206 is received in the inner concave portion 2233, and engaging with the annular groove 20531 of the shaft 205.

When expanding the flexible screen 50 causes the reel 201 to rotate, the shaft 205 remains stationary, the first end cover 202 rotates with the reel 201, the second end cover 203 remains stationary, and one end of the spring 204 fixed to the first end cover 202 rotates with the reel 201, and the other end of the spring 204 fixed to the second end cover 203 remains stationary. Therefore, the spring 204 is twisted and elastically deformed to generate a resilience for pulling back the reel 201 to rotate in a reversed direction.

Due to a limitation of the rotation limiting structure, the reel 201 will not be able to rebound automatically, unless the user manually pushes the first main body 10 and the second main body 20 to move close to each other, and the friction of the rotation limiting structure is offset by the user's thrust. The resilience generated by the spring 204 drives the reel 201 and the flexible screen 50 to roll up. After the user stops pushing, due to an inertia of the rotation of the spring 204 and the reel 201, the reel 201 will continue to rotate against the resistance of the rotation limiting structure until the flexible screen 50 is fully rolled.

When it is necessary to adjust a tightness degree of the spring 204, the buckle 207 can be manually taken out from the locking groove 2232, and a head end of the shaft 205 is rotated by a screwdriver to rotate the shaft 205. Because the limiting surface 2035 of the second end cover 203 and the second stopping surface P2 of the shaft 205 abut against each other; the shaft 205 will drive the second end cover 203 to rotate, and further drive the other end of spring 204 which is fixed to the second end cover 203 to rotate. At this time, the first end cover 202 is pulled by the flexible screen 50 to keep stationary, so, the end of the spring 204 which is fixed to the first end cover 202 also keeps stationary. While one end of the spring 204 moves, and the other end of the spring 204 keeps stationary, the tightness degree of the spring 204 changes. After completing adjustment, the buckle 207 is inserted into the locking groove 2232 to re-position the shaft 205. It should be noted that the tightness degree of the spring 204 can only be adjusted by an integral multiple of a half turn, otherwise the first stopping surface P1 and the second stopping surface P2 of the shaft 205 are not in a vertical position after the adjustment; the positioning groove of the buckle 207 cannot smoothly abut against the first stopping surface P1 and the second stopping surface P2 of the shaft 205.

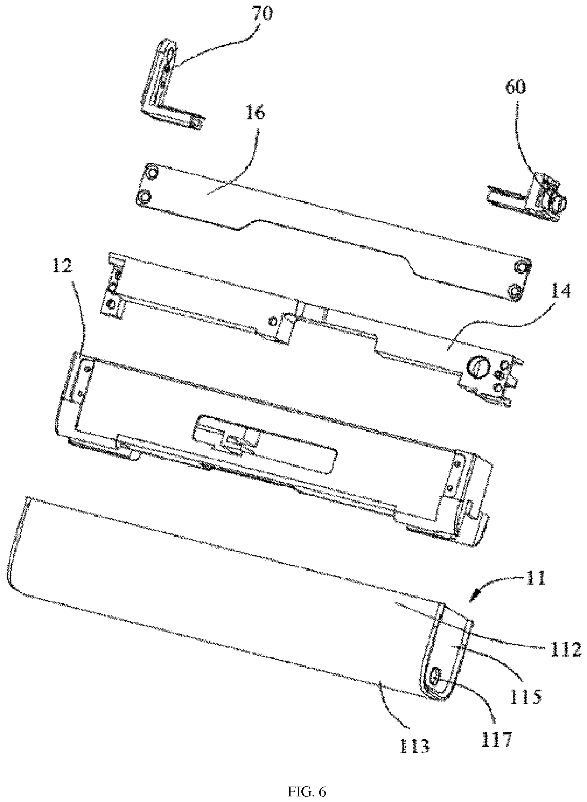

As shown in FIG. 6, the supporting assembly 100 of the display device provided by the present disclosure includes electronic components. The electronic components may be the switch module button 60 and the charging connector 70. In one embodiment, the present disclosure mounts the electronic components together with a connecting piece to the bracket to form an assembly, and then mounts the assembly to the foundation support 12.

The present disclosure provides a display device including a housing which includes electronic components and a supporting assembly for supporting a display screen. The supporting assembly includes a foundation support and a connecting piece. Inside of the foundation support is provided with a circuit board electrically coupled to the display screen. One side of the foundation support is provided with a conductive sheet electrically coupled to the circuit board. The connecting piece includes an abutting piece electrically coupled to the electronic components and a supporting piece extending from the abutting piece. The connecting piece is fixed to the housing. The supporting piece abuts against the conductive sheet through a thimble to realize electrical connections. Details are as follows.

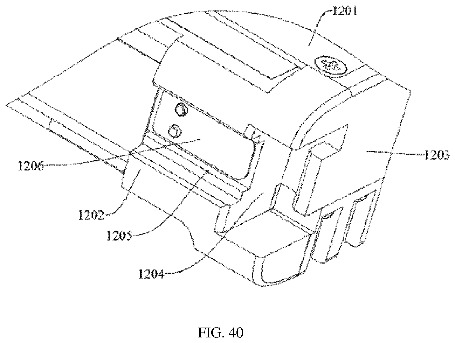

Specifically, referring to FIG. 40, the foundation support 12 includes a top surface 1201, a side surface 1202, and an end surface 1203 adjacent to each other. The top surface 1201 is used for supporting the display screen. In one embodiment, the display screen is a flexible screen. The end surface 1203 defines a groove 1204. The side surface 1204 defines a through groove 1205 adjacent to the groove 1204 and interconnecting with the through groove 1205. The through groove 1205 interconnects with the receiving space inside of the foundation support 12. The inside of the through hole 1205 is provided with a conductive sheet 1206 electrically coupled to the circuit board which is located inside of the supporting assembly 100. The circuit board is located in the receiving space inside of the foundation support 12. The side surface 1202 is opposite to the first side surface 123 of the foundation support 12. The side surface 1202 in the present embodiment refers to the surface of the foundation support 12 away from the second main body 20.

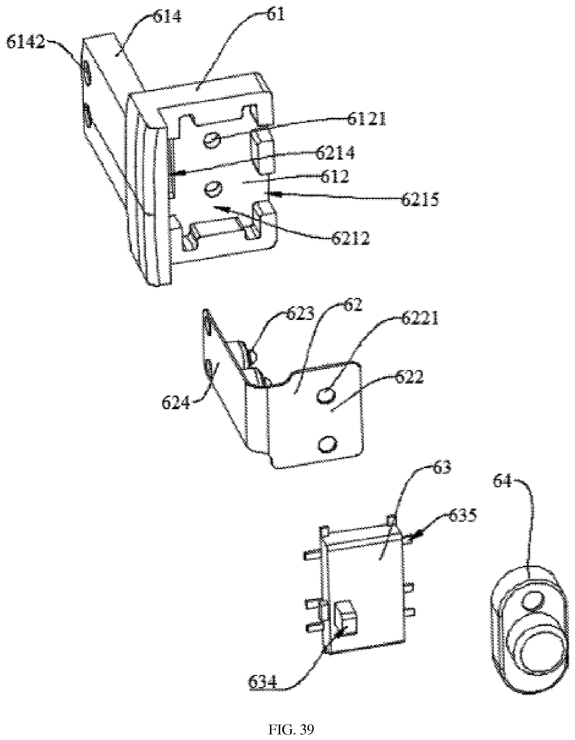

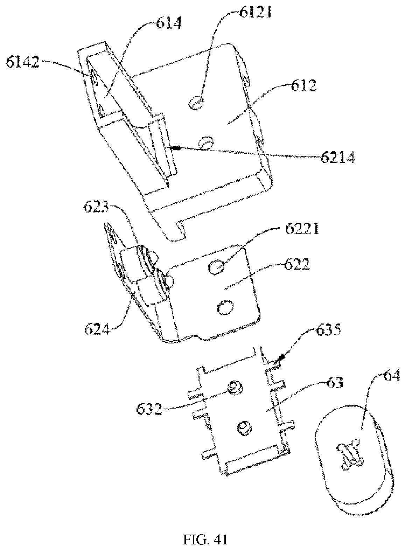

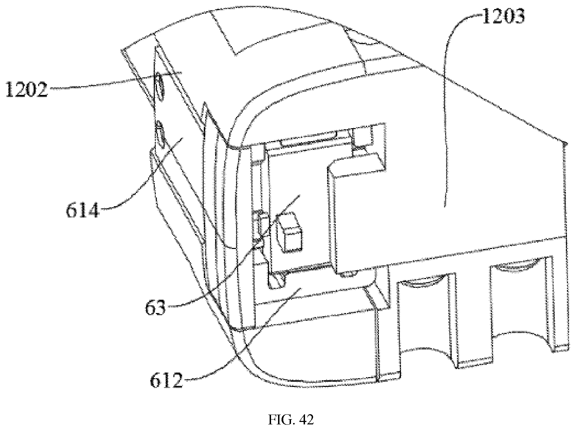

Referring to FIGS. 39, 41 and 42, the switch module button 60 is taken as an example. The supporting assembly includes a bracket 61, a connecting piece 62, an electronic component 63, and a button 64. The bracket 61 includes a fixed plate 612. The fixed plate 612 includes a top surface and a bottom surface. The fixed plate 612 is mounted into the groove 1204. In one embodiment, the bracket 61 is substantially L-shaped; the bracket 61 further includes a spacing plate 614 protrudes from an edge of the bottom surface of the fixed plate 612, and the spacing plate 614 covers the through groove 1205.

The connecting piece 62 includes an abutting piece 622 and a supporting piece 624 bent from an edge of the abutting piece 622. The connecting piece 62 passes through the fixed plate 612. The abutting piece 622 is fixed to the top surface of the fixed plate 612. The supporting piece 624 is located at one side of the bottom surface of the fixed plate 612. The supporting piece 624 is located in the through groove 1205 and is electrically coupled to the conductive sheet 1206 through thimbles 623. In the present embodiment, the thimbles 623 are fixed to the supporting piece 624. The supporting piece 624 is located on one side of the spacing plate 614 facing the through groove.

The electronic component 63 is located in the groove 1204 and is electrically coupled to the abutting piece 622. Specifically, the electronic component 63 includes studs 632. The surface of each stud 632 has a conductive portion. The fixed plate 612 defines receiving holes 6121. The abutting piece 622 defines through holes 6221. Each through hole 6221 faces one receiving hole 6121. When each stub 632 passes through one through hole 6221 and is positioned in one receiving hole 6121, the conductive portion contacts inner edge of the through hole 6221 to realize the electrical connection of electronic component 63 to the abutting piece 622.

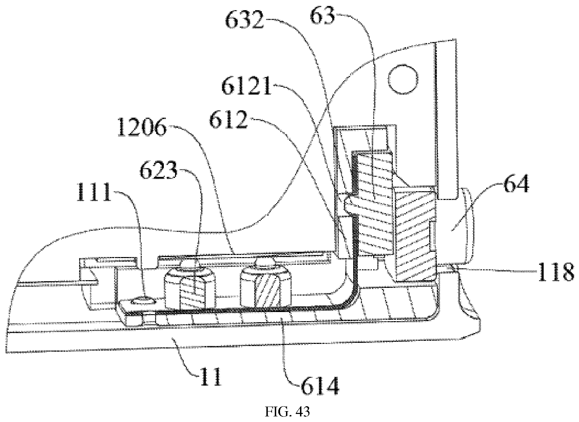

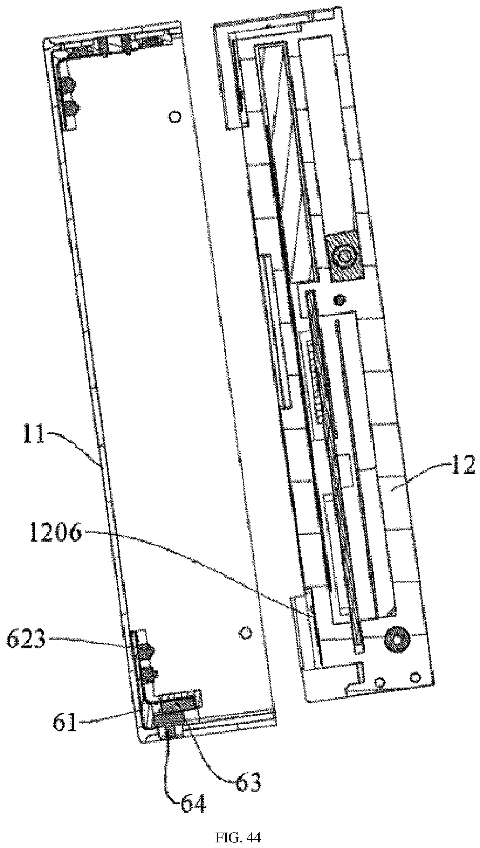

Referring to FIGS. 43 and 44, the housing is used for covering the foundation support 12. The housing in this embodiment refers to a first housing 11. The housing defines a through hole 118. The inner surface of the housing includes a first mounting portion 111. The spacing plate 614 includes a second mounting portion 6142. The first mounting portion 111 mates with the second mounting portion 6142 so that the bracket 61 together with the connecting piece 62 and the electronic component 63 is mounted to the inner surface of the housing (ie, first housing 11), and the through hole 118 is opposite to the electronic component 63. In one embodiment, the first mounting portion 222 of the inner surface of the housing is a fixing post, and the second mounting portion 223 of the spacing plate 614 is a fixing hole, and the fixing post mates with the fixing hole to realize positioning of the bracket 61 and the housing. In other embodiments, the bracket 61 may be fixed to the housing by double-sided adhesive bonding, or may be fixed by buckles engaging with slots.

The groove 1204 of the foundation support 12 defines an opening in a direction of the side surface of the foundation support 12. During a process of the foundation support 12 mounted to the housing, the fixed plate 612 is inserted into the groove 1204 from the opening.

In one embodiment, the electronic component 63 is a switch module. The top surface of the fixed plate 612 defines a slot 6212. The electronic component 63 is received in the slot 6212. The supporting assembly 100 further includes a button 64. The housing defines a through hole 118. One side of the electronic component 63 away from the abutting piece 622 includes a protrusion 634. The protrusion 634 mates with the button 64. The button 64 partially extends out of the through hole 118 of the housing. Pushing the button 64 can cause the electronic component 63 to push the protrusion 634 to slide.

The bottom wall of the slot 6212 defines a slot 6214. The slot 6214 interconnects with the top surface of the fixed plate 612 and the bottom surface of the fixed plate 612. The slot 6214 enables the connecting piece 62 to pass through.

The side wall of the slot 6212 defines a limiting slot 6215. The side of the electronic component 63 includes a limiting strip 635. The limiting slot 6215 mates with the limiting strip 635 to enable the electronic component 63 to be positioned within the slot 6212.

When in assembly, firstly, the bracket 61 together with the connecting piece 62 and the electronic component 63 is mounted to the inner surface of the housing (ie, the first housing 11) through the first mounting portion 111 engaging with the second mounting portion 6142. At this time, the through hole 118 is opposite to the electronic component 63. Thereby, pre-assembly of the electronic component 63 is accomplished. Then, the foundation support 12 fixed with the conductive sheet 1206 is brought close to the housing (ie, the first housing 11) until the thimbles abut against the conductive sheet 1206 on the foundation support 12. At this time, the conductive sheet 1206 conducts the thimbles with circuit board in the foundation support 12, thereby achieving to power the electronic component. The installation method of the thimbles abutting against the conductive sheet 1206 can avoid a problem that wires are easily damaged during the installation process, and the installation process is relatively simple.

In one embodiment, the thimbles is fixed to one side of the supporting piece 624 of the connecting piece 62 facing the foundation support 12. In other embodiments, the thimbles can also be fixedly attached to the conductive sheet 1206 on the foundation support 12.

In another embodiment, the electronic component is the charging connector 70. The electronic component is provided with a charging interface. The supporting assembly 100 further includes a housing for covering the foundation support 12. The housing defines a through hole 117 (as shown in FIG. 5). The through hole 117 faces the charging interface. The through hole is used for a charging connector passing through the through hole 117 so as to mate with the charging interface.

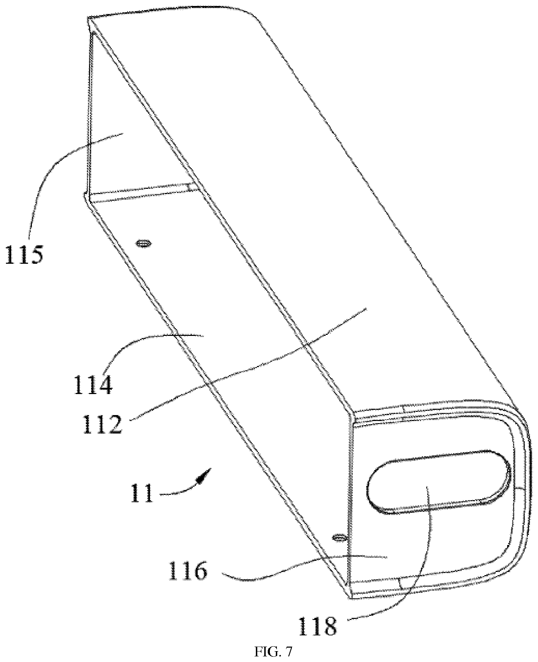

As shown in FIG. 44, one end of the foundation support 12 includes a switch module, and the other end of the foundation support 12 includes a charging module. Referring to FIGS. 5 and 7, the front end surface of the first housing 11 defines a through hole 118 for receiving the switch module button 64; the rear end surface of the first housing 11 defines a through hole 117 for receiving the charging interface.

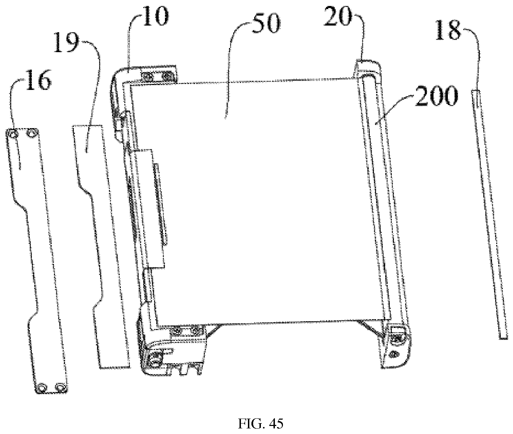

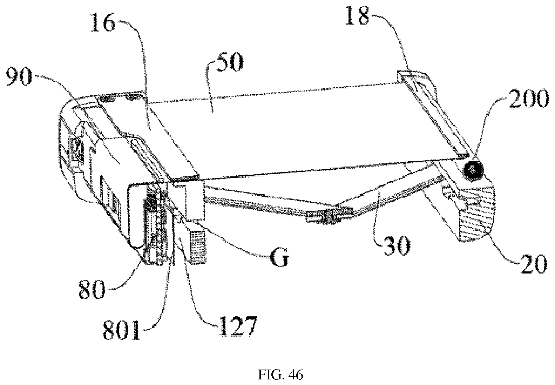

Referring to FIGS. 45 and 46, the first main body 10 further includes a first backing plate 19. The first pressing plate 16 and the first backing plate 19 are stacked on the top surface of the foundation support 12. The first backing plate 19 is attached to one surface of the first pressing plate 16 facing the flexible screen 50 to protect the flexible screen 50. The first backing plate 19 may be made of soft materials such as a sponge, to avoid damage to the flexible screen 50.

The second main body 20 includes a second pressing plate 18 mounted to the mounting portion and located on one side of the reel assembly 200 away from the top surface of the second main body 20. The flexible screen 50 pass through a gap between the second pressing plate 18 and the reel assembly 200.

Referring to FIG. 46, the flexible screen 50 is electrically coupled to the circuit board through an FPC 90. One portion of the FPC 90 located at the surface of the foundation support 12 away from the second main body 20 is in the folded state. In one embodiment, the FPC 90 is folded in U-shape at the surface of the foundation support 12 away from the second main body 20. The FPC 90 is fixedly coupled to the circuit board 80 by bypassing the surface of the foundation support 12 from top to bottom. Since the flexible screen 50 is fixed to the FPC 90, the flexible screen 50 has no fixed relationship with the foundation support 12. Therefore, setting the FPC 90 to bypass the surface of the foundation support 12 can increase friction between the FPC 90 and the foundation support 12, which avoid the flexible screen 50 of pulling the FPC during the expanding process, thereby ensuring the safety and stability of the electrical connection line.

The first main body 10 further includes a shielding plate 801 located in the circuit cavity 127 of the foundation support 12 to isolate the circuit board 80 in the circuit cavity 127 from the gap G. In one embodiment, the shielding plate 801 is made of heat conductive materials that not only shield the circuit board 80 but also provides heat dissipation for the circuit board 80.

Finally, it should be noted that the above embodiments are only used for explaining the technical solutions of the present disclosure, and are not limited thereto; although the present disclosure is described in detail with reference to the foregoing embodiments, those skill in the art should understand that: the scope of the present disclosure is not limited thereto, and any changes or substitutions that can be easily conceived by those skill in the art within the scope of the technical scope of the present disclosure are covered by the scope of the present disclosure. Therefore, the protection scope of the present disclosure is subject to the protection scope of the claims.

## Claims

1. A display device comprising a housing which comprises electronic components and a supporting assembly for supporting a display screen, wherein the supporting assembly comprises:
a foundation support, inside of the foundation support provided with a circuit board electrically coupled to the display screen, and one side of the foundation support is provided with a conductive sheet electrically coupled to the circuit board;
a connecting piece comprising an abutting piece electrically coupled to the electronic components and a supporting piece extending from the abutting piece; wherein, the connecting piece is fixed to the housing; the supporting piece abuts against the conductive sheet through thimbles to realize electrical connections.

2. The display device according to claim 1, wherein, the supporting assembly further comprises a bracket fixedly coupled to the housing; the bracket comprises a fixed plate; the fixed plate comprises a first surface and a second surface; the supporting piece extends to one side of the first surface of the fixed plate; the electronic components are fixed to the second surface of the fixed plate; the abutting piece is located between the electronic components and the fixed plate.

3. The display device according to claim 2, wherein, the bracket further comprises a spacing plate protruding from an edge of the first surface of the fixed plate; the supporting piece is located on one side of the spacing plate facing the conductive sheet.

4. The display device according to claim 3, wherein, the housing defines a through hole; an inner surface of the housing comprises a first mounting portion; the spacing plate comprises a second mounting portion; the second mounting portion mates with the second mounting portion to mount the bracket together with the connecting piece and the electronic components to the inner surface of the housing; the through hole is opposite the electronic components.

5. The display device according to claim 2, wherein, the electronic components comprise studs; one surface of each stud comprises a conductive portion; the fixed plate defines receiving holes; the abutting piece defines through holes, each through hole is opposite to one receiving hole; the conductive portion is in contact with inner walls of the through holes; when each stud passes through one through hole and is positioned in one receiving hole, an electrical connection between the electronic components and the abutting piece is achieved.

6. The display device according to claim 5, wherein, the electronic components comprise a switch module; a second surface of the fixed plate defines a slot; and the electronic components are received in the slot.

7. The display device according to claim 6, wherein, the supporting assembly further comprises a button; the housing defines a through hole; and one side of the electronic components away from the abutting piece comprises a protrusion; the protrusion mates with the button; a portion of the button extending out the housing defines the through hole.

8. The display device according to claim 6, wherein, a bottom wall of the slot defines a slot, the slot is interconnected to a top surface of the fixed plate and a bottom surface of the fixed plate; and the slot is used for the connecting piece passing through.

9. The display device according to claim 6 , wherein a side wall of the slot defines a limiting slot; and a side of the electronic components comprises a limiting strip, and the limiting slot is mated with the limiting slot to limit the electronic components within the slot.

10. The display device according to claim 5, wherein, the electronic components comprise a charging connector, the electronic components comprise a charging interface; the housing defines a through hole; the through hole is opposite to the charging interface for a charging connector passing through the through hole, and mating with the charging interface.

11. The display device according to claim 3, wherein, the foundation support comprises a top surface, a side surface and an end surface adjacent to each other; the top surface is used for supporting the display screen; the end surface defines a groove; the side surface defines a through groove interconnected with the groove; the conductive sheet is received in the through groove; the spacing plate blocks the through groove; and the fixed plate is installed in the groove.

12. The display device according to claim 11, wherein the groove of the foundation support defines an opening at a direction of a side surface of the foundation support; during a process of the foundation support mounting into the housing, the fixed plate is inserted into the groove from the opening.

13. The display device according to claim 11, wherein, the foundation support further comprises a bottom surface; the bottom surface of the foundation support defines a circuit cavity; and the circuit cavity is used for receiving the circuit board.

14. The display device according to claim 13, wherein the supporting assembly further comprises a base plate mounted to the bottom surface of the foundation support; the base plate and the foundation support cooperatively forms a first main body; the supporting assembly further comprises a second main body opposite to the first main body and a rod assembly coupled between the first main body and the second main body; the rod assembly comprising at least two connecting rods hinged to each other to form a telescopic structure.

15. The display device according to claim 14, wherein, the base plate and the foundation support cooperatively form a gap for the rod assembly reaching into or protruding from the gap; the supporting assembly further comprises a shielding plate located in the circuit cavity; and the shielding plate isolates the circuit board in the circuit cavity from the gap.

16. The display device according to claim 15, wherein a surface of the base plate facing the bottom surface of the foundation support comprises a step for limiting with the rod assembly in a contracted state.

17. The display device according to claim 13, wherein the bottom surface of the foundation support defines a battery cavity for receiving a battery; and the battery cavity is located between the limiting slot and a side surface of the foundation support.

18. The display device according to claim 17, wherein, a buckle is located between the battery cavity and the circuit cavity; the buckle defines a first slot; a second slot is defined between the first limiting part and the side surface; and the first slot is opposite to the second slot; and the first slot and the second slot are cooperatively used for co-locating the circuit board.

19. The display device according to claim 11, wherein the display screen is a flexible screen, and the flexible screen is electrically coupled to the circuit board through an FPC, and one part of the FPC located in a side surface of the foundation support is in a contracted state.

20. A mobile terminal, comprising the display device according to any one of claims 1-19.
